# EUROPÄISCHE PATENTSCHRIFT

(11) **EP 1 703 784 B1**
(45) Veröffentlichungstag und Bekanntmachung des Hinweises auf die Patenterteilung: **02.07.2008**
(21) Anmeldenummer: 06101665.5
(22) Anmeldetag: 14.02.2006
(51) Int. Cl.: H05K 13/04

(54) **Trägerarm, insbesondere zum Tragen eines Bestückkopfes für einen Bestückautomat, und Bestückautomat zum Bestücken von Substraten mit elektrischen Bauelementen**
Arm for supporting a head of a mounting device, and mounting device for assembling substrates with electrical components
Bras de support d'une tête d'un dispositif de montage, et dispositif de montage pour monter des composants électriques sur des substrats

(30) Priorität: 17.03.2005 DE 102005012401
(43) Veröffentlichungstag der Anmeldung: 20.09.2006
(73) Patentinhaber: SIEMENS AKTIENGESELLSCHAFT, 80333 München (DE)
(72) Erfinder: Grässle, Andreas, 81545 München (DE); Krupke, Susan, 81475 München (DE); Stingl, Rudolf, 81541 München (DE)

(56) Entgegenhaltungen:
- DE-A1- 10 309 879

## Beschreibung

Trägerarm, insbesondere zum Tragen eines Bestückkopfes für einen Bestückautomat, und Bestückautomat zum Bestücken von Substraten mit elektrischen Bauelementen

Die Erfindung betrifft einen Trägerarm, insbesondere zum Tragen eines Bestückkopfes für einen Bestückautomat zum Bestücken von Substraten mit elektrischen Bauelementen, sowie einen entsprechenden Bestückautomat mit einem derartigen Trägerarm.

Aus dem Stand der Technik sind Anwendungen bekannt, bei denen an einem Trägerarm aus kohlefaserverstärktem Kunststoff Anbauelemente aus einem anderen Werkstoff, beispielsweise Flanschelemente aus Stahl oder Aluminium, befestigt sind. So ist aus der Offenlegungsschrift DE 10309879 ein Bestückautomat mit einem Positionierarm aus kohlefaserverstärktem Kunststoff für einen Bestückkopf bekannt. Am Fußteil des Positionierarmes sind Führungselemente befestigt, die in Führungsschienen einer Längsführung des Bestückautomaten eingreifen. Die Führungselemente sind in der Regel aus einem metallischen Werkstoff, beispielsweise Aluminium, gefertigt. Aufgrund des sehr unterschiedlichen thermischen Ausdehnungsverhaltens des Positionierarmes aus kohlefaserverstärktem Kunststoff und dem daran befestigten Führungselementen aus metallischem Werkstoff kann es bei Temperaturänderungen zu thermischen Verformungen kommen. Dies kann zu einer Beeinträchtigung der Positioniergenauigkeit des Positionierarmes führen.

Es ist deshalb die Aufgabe der vorliegenden Erfindung, einen Trägerarm und einen Bestückautomat mit einer erhöhten Positioniergenauigkeit zu liefern.

Diese Aufgabe wird durch die Gegenstände der unabhängigen Ansprüche erfüllt.

Ein Trägerarm gemäß dem Anspruch 1 weist einen Grundkörper aus kohlefaser- bzw. carbonfaserverstärktem Kunststoff (CFK) auf. Ein Anbauelement ist mit einer Montagefläche in einem Montagebereich am Trägerarm befestigt. Das Anbauelement kann einen Werkstoff aufweisen, der von kohlefaserverstärktem Kunststoff unterschiedlich ist, beispielsweise Metall. Der Trägerarm umfasst ferner ein Unterstützungselement aus glasfaserverstärktem Kunststoff (GFK), welches im Montagebereich mit dem Grundkörper derart verbunden ist, dass die Montagefläche des Anbauelements zumindest teilweise von zwei übereinander angeordneten Schichten aus kohlefaserverstärktem Kunststoff des Grundkörpers und glasfaserverstärktem Kunststoff des Unterstützungselements unterlegt ist. Bei dem erfindungsgemäßen Trägerarm kann das Unterstützungselement und der Grundkörper im Montagebereich derart aufeinander abgestimmt werden, dass das thermische Ausdehnungsverhalten der Gesamtheit der Schichten aus kohlefaserverstärktem Kunststoff des Grundkörpers und glasfaserverstärktem Kunststoff des Unterstützungselements dem thermischen Ausdehnungsverhalten der Führungseinrichtung ähnlicher ist als das thermische Ausdehnungsverhalten des kohlefaserverstärkten Kunststoffs des Grundkörpers allein. Dies ist durch eine entsprechende Auslegung derjenigen Parameter möglich, welche das Ausdehnungsverhalten der Schicht aus kohlefaserverstärktem Kunststoff und der Schicht aus glasfaserverstärktem Kunststoff bestimmen, beispielsweise die Schichtdicke, Orientierung der Kohle- bzw. Glasfasern etc. Der Erfindung liegt daher die Idee zugrunde, das thermische Ausdehnungsverhalten des Trägerarms im Montagebereich durch Überlagerung zweier zu einer Einheit fest verbundener Schichten aus jeweils kohlefaserverstärktem Kunststoff und glasfaserverstärktem Kunststoff durch entsprechende Auslegung derart zu manipulieren, dass es dem thermischen Ausdehnungsverhalten des Anbauelements möglichst nahe kommt. Dadurch kann die thermische Verformung deutlich reduziert werden. Somit kann ferner die Lagerbelastung der Führungseinrichtung deutlich verringert werden. Glasfaserverstärkter Kunststoff bietet darüber hinaus die Vorteile eines geringen Gewichts und einer hohen Steifigkeit, wodurch das Anbauelement gut abgestützt und das Gewicht des Trägerarms weitgehend gering gehalten werden kann.

Bei der Ausgestaltung des Trägerarms gemäß Anspruch 2 ist die Montagefläche des Anbauelements von den durch den Grundkörper und das Unterstützungselement gebildeten übereinander liegenden Schichten vollständig unterlegt. Dadurch werden thermische Verformungen weitgehend reduziert und das Anbauelement ist am Trägerarm gut stabilisiert.

Der Trägerarm kann auch gemäß Anspruch 3 dahingehend ausgestaltet werden, dass mehrere Anbauelemente beispielsweise in verschiedenen Montagebereichen am Trägerarm befestigt sind. Dabei ist für jedes Anbauelement jeweils ein Unterstützungselement vorgesehen. Durch diese Anordnung wird der Einsatz des Unterstützungselements auf die nötigen Stellen am Trägerarm reduziert, was zur Optimierung des Gewichts des Trägerarms beiträgt.

Der Grundkörper des Trägerarms kann gemäß Anspruch 4 als kastenförmiger Hohlkörper ausgestaltet sein, wobei jede Seitenwand des Grundkörpers, an der ein Anbauelement befestigt ist, aus zwei übereinander angeordneten, beabstandeten Platten aus kohlefaserverstärktem Kunststoff ausgebildet ist. Das Unterstützungselement ist dabei im Montagebereich in dem von den kohlefaserverstärkten Kunststoffplatten gebildeten Hohlraum angeordnet und mit diesen verbunden. Diese Ausgestaltung des Trägerarms erlaubt eine einfache Fertigungsweise und eine weitere Gewichtsreduzierung, da die kohlefaserverstärkten Kunststoffplatten entsprechend dünn ausgebildet sein können.

Der zwischen den beiden Platten aus kohlefaserverstärktem Kunststoff gebildete Hohlraum kann gemäß einer Ausgestaltung nach Anspruch 5 in dem Bereich, der nicht vom Unterstützungselement eingenommen wird, mit Schaumstoff ausgefüllt werden. Der Schaumstoff stabilisiert die beiden beabstandeten kohlefaserverstärkten Kunststoffplatten in den Bereichen, in denen eine Stabilisierung durch das Unterstützungselement fehlt. Gleichzeitig wird das Gewicht des Trägerarmes nur unwesentlich erhöht.

Bei der Ausgestaltung des Trägerarms gemäß Anspruch 6 weist das Anbauelement einen metallischen Werkstoff, insbesondere eine Aluminium-Silizium-Legierung auf. Die Aluminium-Silizium-Legierung hat gegenüber reinem Aluminium bzw. anderer Aluminium-Legierungen den Vorteil, dass das thermische Ausdehnungsverhalten der Aluminium-Silizium-Legierung dem thermischen Ausdehnungsverhalten des kohlefaserverstärkten Kunststoffs ähnlicher ist. Dies erleichtert die Anpassung des thermischen Ausdehnungsverhaltens Trägerarms am Montagebereich mit dem des Anbauelements.

Bei dem Trägerarm kann es sich gemäß Anspruch 7 um einen Trägerarm zum Tragen eines Bestückkopfs für einen Bestückautomaten zum Bestücken von Substraten mit elektrischen Bauelementen handeln, wobei das Anbauelement eine Führungseinrichtung ist, welche am Trägerarm befestigt ist, so dass sie mit Schienen einer Linearführung des Bestückautomaten in Eingriff bringbar ist. Wie weiter oben schon erwähnt wurde, sind die Führungseinrichtungen meist aus einem metallischen Werkstoff, beispielsweise einer Aluminium-Legierung gefertigt, wobei die Führungseinrichtung einen erheblichen Einfluss auf die Positioniergenauigkeit des Trägerarms hat. Durch den erfindungsgemäßen Trägerarm können die thermischen Spannungen zwischen der Führungseinrichtung und dem Montagebereich am Trägerarm erheblich reduziert werden, was dem Auftreten des so genannten Bimetall-Effekts, bei dem sich die Führungseinrichtung aufgrund thermischer Spannungen verformt, entgegenwirkt. Dadurch kann die Positioniergenauigkeit des Trägerarms deutlich erhöht werden.

Der Bestückautomat gemäß dem unabhängigen Anspruch 8 weist einen Trägerarm gemäß den vorangehenden Ansprüchen auf. Die genannten Vorteile der einzelnen Ausgestaltungen des Trägerarms gemäß den Ansprüchen 1 bis 7 gelten analog.

Im Folgenden wird ein Anwendungsbeispiel des erfindungsgemäßen Trägerarmes bzw. ein Ausführungsbeispiel des erfindungsgemäßen Bestückautomaten mit Bezug auf die beigefügten Zeichnungen näher beschrieben. In den Zeichnungen sind
Fig. 1 eine schematische Darstellung eines Ausführungsbeispiels des erfindungsgemäßen Bestückautomaten mit einem erfindungsgemäßen Trägerarm,
Fig. 2 eine perspektivische Detailansicht eines Ausführungsbeispiels des erfindungsgemäßen Trägerarmes,
Fig. 3 einen Teil des Trägerarmes ohne Anbauelemente,
Fig. 4 eine schematische Querschnittsansicht des in Fig. 3 gezeigten Trägerarms entlang der Schnittlinie A-A, welche den Schichtaufbau des Trägerarmes im Montagebereich näher verdeutlicht,
Fig. 5 eine Ansicht des Trägerarmes, welche den genauen Aufbau der Seitenwände darstellt, und
Fig. 6 eine Ansicht des gesamten Trägerarms mit Führungselementen.

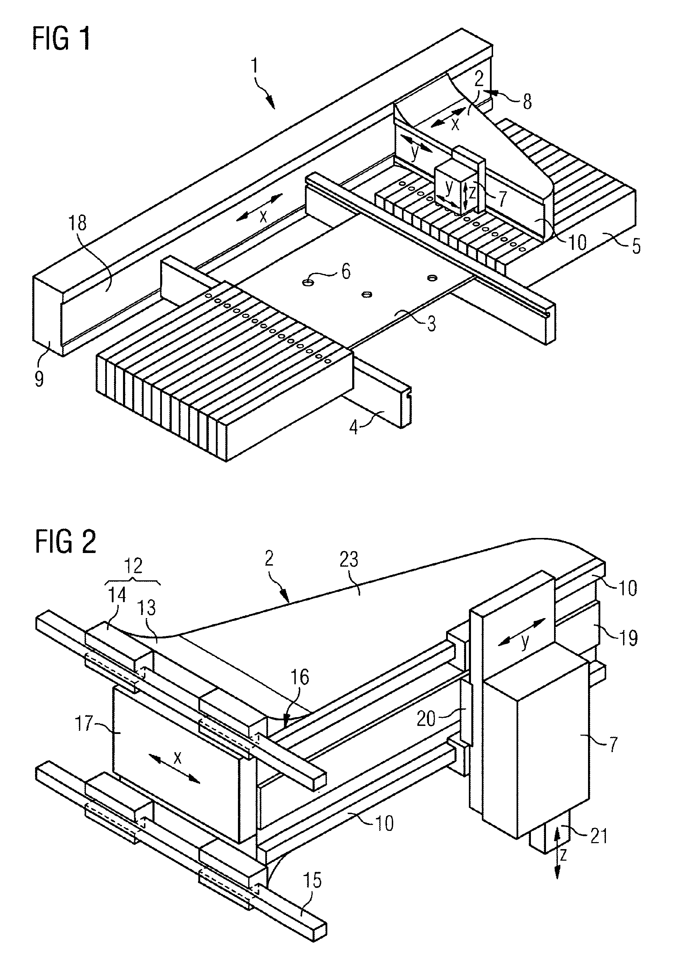

In Fig. 1 sind Teile eines erfindungsgemäßen Bestückautomats 1 mit einem erfindungsgemäßen Trägerarm 2 schematisch dargestellt. Ein zu bestückendes Substrat 3 wird über eine Transportstrecke 4 zu einem Bestückplatz des Bestückautomats 1 befördert. Seitlich der Transportstrecke 4 befinden sich in Abholbereichen mehrere Zuführeinrichtungen 5, welche die auf das Substrat 3 zu platzierenden elektrische Bauelemente 6 bereitstellen. Im Ausführungsbeispiel ist ein Bestückkopf 7 zwischen den Abholbereichen und dem Bestückplatz mittels eines zweidimensionalen Positioniersystems 8 verfahrbar, um Bauelemente 6 aufzunehmen und auf dem Substrat 3 abzusetzen. Dabei ist der Trägerarm 2 mittels eines Linearmotors (siehe Fig. 2) in einer Längsrichtung x entlang einer Linearführung 9 des Bestückautomats 1 verfahrbar. Am Trägerarm 2 selbst ist der Bestückkopf 7 an einer Querführung 10 mittels eines weiteren Linearmotors (siehe Fig. 2) in einer Querrichtung y senkrecht zur Längsrichtung x des Trägerarmes 2 verfahrbar angeordnet.

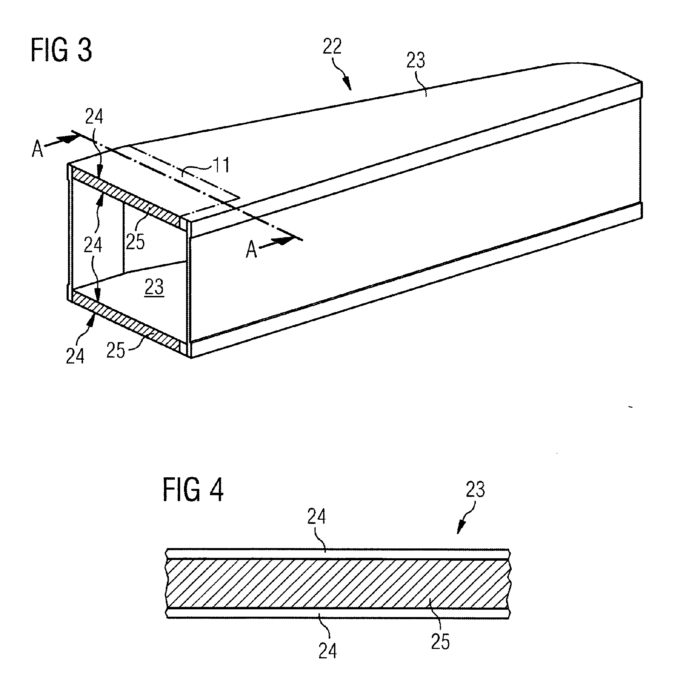

In Fig. 2 ist der in Fig. 1 gezeigte Trägerarm 2 vergrößert dargestellt. Der Trägerarm 2 weist eine kastenförmige Struktur auf, die sich zu einem freistehenden Ende hin verjüngt. An der Oberseite und Unterseite am Fußteil des Trägerarmes 2 ist jeweils in einem Montagebereich 11 (siehe Fig. 3) ein Anbauelement 12 in Form einer Führungseinrichtung 12 befestigt. Die Führungseinrichtung 12 besteht beispielsweise aus einem Montagewinkel 13 und daran befestigten Führungswagen 14, sodass sie mit entsprechenden Schienen 15 (in Fig. 2 gestrichelt dargestellt) der Linearführung 9 des Bestückautomats 1 in Eingriff bringbar sind. Jede Führungseinrichtung 12 weist eine Montagefläche 16, im Falle des Ausführungsbeispiels die dem Trägerarm 2 zugewandte Fläche des Montagewinkels 13, auf, mit der die Führungseinrichtung 12 im Montagebereich 11 am Trägerarm 2 befestigt ist. An der Stoßfläche des Fußteils des Trägerarmes 2 befindet sich zwischen den Führungseinrichtungen 12 ein mobiles Spulenteil 17 eines Linearmotors, welches mit zwischen den Schienen 15 der Linearführung 9 des Bestückautomats 1 befindlichem stationärem Permanentmagneten 18 in Wechselwirkung bringbar ist, um den Trägerarm 2 entlang der Linearführung 9 des Bestückautomats 1 zu bewegen.

An einer Seitenfläche des Trägerarmes sind die Querführung 10 und weitere Permanentmagnete 19 als stationärer Teil eines weiteren Linearmotors angeordnet. Der Bestückkopf 7, an dem ein weiteres mobiles Spulenteil 20 des weiteren Linearmotors und Führungswagen angebracht sind, ist entlang der Querführung 10 verfahrbar. Der Bestückkopf 7 weist darüber hinaus eine oder auch mehrere Greifermodule 21 zur Aufnahme und zum Absetzen der elektrischen Bauelemente 6 auf, welche in einer Richtung z senkrecht zu einer Bestückebene verfahrbar ausgebildet sind.

In Fig. 3 ist er Trägerarm 2 ohne Anbauelement 12 dargestellt. Ein in Form eines kastenförmigen Hohlkörpers ausgebildeter Grundkörper 22 des Trägerarmes 2 besteht im Wesentlichen aus kohlefaserverstärktem Kunststoff (CFK). Die Seiten des Grundkörpers 22, an denen keine Montagebereiche 11 für die Anbauelemente 12, d.h. die Führungseinrichtungen 12, vorgesehen sind, sind als formstabile CFK-Platten ausgeführt. Im Gegensatz dazu weisen diejenigen Seitenwände 23 des Trägerarmes, welche Montagebereiche 11 für die Führungseinrichtung 12 aufweisen, eine mehrschichtige Struktur auf. Im Falle des Ausführungsbeispiels in Fig. 3 handelt es sich dabei um die obere und die untere Seitenwand 23 des Trägerarmes 2.

Eine Teilansicht eines Querschnitts im Montagebereich 11 der oberen Seitenwand 23 des Trägerarmes entlang der strichpunktierten Linie A-A in Fig. 3 ist in Fig. 4 vergrößert dargestellt. Die Seitenwand 23 besteht aus zwei übereinander angeordneten, beabstandeten Schichten 24 aus CFK-Material in Form dünner CFK-Platten 24, welche dem Grundkörper 22 des Trägerarmes zugeordnet sind. In dem zwischen den CFK-Platten 24 gebildeten Hohlraum befindet sich im Montagebereich 11 ein Unterstützungselement 25 aus glasfaserverstärktem Kunststoff (GFK). Wie in Fig. 3 durch eine gestrichelte Linie dargestellt, erstreckt sich das Unterstützungselement 25 innerhalb der Seitenwand 23 des Trägerarmes über den gesamten Montagebereich 11, an der das (in Fig. 3 nicht dargestellte) Anbauelement 12 bzw. die Führungseinrichtung 12 an dem Trägerarm 2 zu befestigen ist.

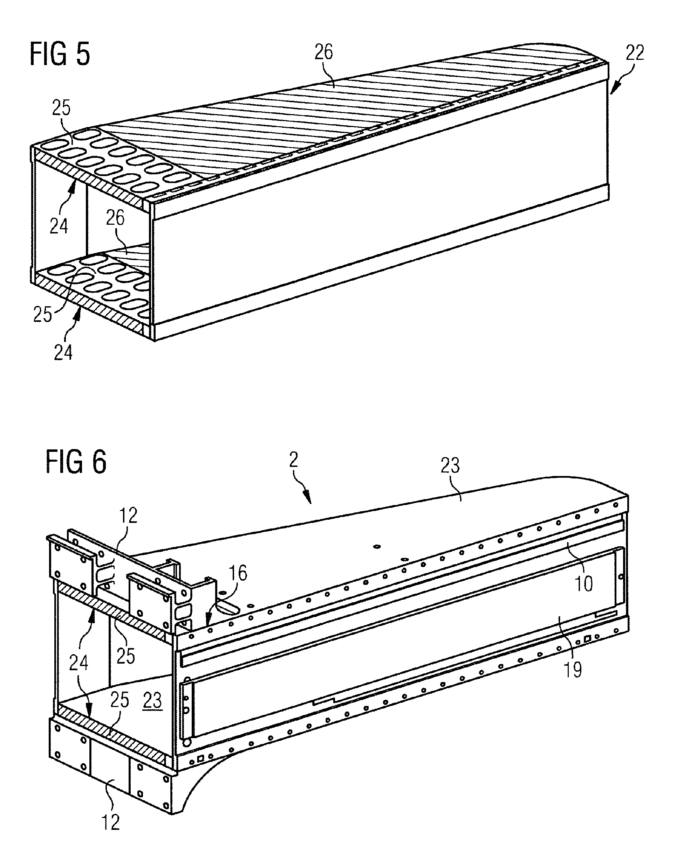

Zur weiteren Verdeutlichung des inneren Aufbaus der beiden, die Montagebereiche 11 aufweisenden Seitenwände 23 ist der Trägerarm 2 in Fig. 5 ohne die jeweils abdeckende, obere CFK-Platte 24 des Grundkörpers 22 dargestellt. Bei der oberen und der unteren Seitenwand 23 ist jeweils der zwischen den beiden CFK-Platten 24 ausgebildete Zwischenraum im Montagebereich 11 durch ein Unterstützungselement 25 aus glasfaserverstärktem Kunststoff und im restlichen Bereich durch einen Schaumstoffkörper 26 ausgefüllt. Das Unterstützungselement 25 ist zur Gewichtsverringerung mit Löchern versehen. Der Schaumstoff dient lediglich der Stabilisierung der Seitenwände in dem Bereich, wo sich kein Unterstützungselement 25 befindet, ohne dabei das Gewicht des Trägerarmes wesentlich zu erhöhen.

In Fig. 6 ist der Trägerarm 2 mit Führungseinrichtungen 12 dargestellt, welche in den jeweiligen Montagebereichen 11 der oberen und unteren Seitenwand 23 des Trägerarmes 2 befestigt sind.

Die Führungseinrichtungen 12 sind im Ausführungsbeispiel aus einer Aluminium-Silizium-Legierung gefertigt und sind mittels der Montagefläche 16 mit dem Grundkörper 22 des Trägerarmes 2verklebt. Da das Unterstützungselement 25, wie vorher erwähnt, über den gesamten Montagebereich 11 erstreckt, sind die Führungseinrichtungen 12 vollständig von zwei übereinander angeordneten Schichten bzw. Platten 24 aus kohlefaserverstärkten Kunststoff des Grundkörpers 22 und glasfaserverstärkten Kunststoff des Unterstützungselements 25 unterlegt.

Die der Erfindung zugrunde liegende Idee, im Montagebereich 11 die Anbauelemente 12 bzw. die Führungseinrichtungen 12 durch die zwei übereinander angeordneten Schichten aus CFK-Platten 24 des Grundkörpers 22 und des GFK-Körpers des Unterstützungselements 25 zu unterlegen, wird im Folgenden näher erläutert.

Wie oben erwähnt, bestehen die Führungseinrichtungen 12 aus einer Aluminium-Legierung. Aluminium zeigt im Vergleich zu kohlefaserverstärktem Kunststoff ein sehr unterschiedliches Wärmedehnungsverhalten. So weist Aluminium einen Wärmeausdehnungskoeffizienten im Bereich von 23 X 10⁻⁶ pro Kelvin auf, während sich der Wärmeausdehnungskoeffizient von CFK in Faserrichtung im Bereich von 0 befindet. Bei Temperaturschwankungen, beispielsweise bei einer Erwärmung des Trägerarmes 2 durch die Wärmeleitung des am Fußteil des Trägerarmes 2 befindlichen mobilen Spulenteils 17 des Linearmotors, würde es in dem Fall, dass die Führungseinrichtung 12 lediglich auf einer dicken CFK-Platte befestigt ist, zu erheblichen thermischen Spannungen kommen. Aufgrund der thermischen Spannungen würde ein Bimetalleffekt auftreten, bei dem sich die Führungseinrichtungen 12 verformen, was zu einer deutlichen Verminderung der Führungseigenschaften der Linearführung 9 des Bestückautomats 1 und damit der Positioniergenauigkeit des Trägerarmes 2 führen würde.

Erfindungsgemäß ist die Montagefläche 16 der Führungseinrichtung 12 im Montagebereich 11 jedoch durch zwei übereinander liegende Schichten bzw. Platten 24 aus dem CFK-Material des Grundkörpers 22 und dem GFK-Materials des Unterstützungselements 25 unterlegt. Bei der Herstellung der Seitenwände 23 mit einem Montagebereich 11 für die Führungseinrichtungen 12 werden zwischen die zwei mit Harz getränkten, dünnen CFK-Schichten das Unterstützungselement 25 aus GFK und der Schaumstoffkörper 26 angeordnet. Diese Konstruktion wird dann in einem Ofen aufgehärtet, wodurch sich der GFK-Körper des Unterstützungselements 25 und die CFK-Platten 24 des Grundkörpers 22 sehr fest zu einer Einheit verbinden. Durch die extrem starke Verbindung dehnen sich die GFK-Schicht und die CFK-Schicht bei Temperaturerhöhung nicht mehr getrennt sondern nur noch gemeinsam aus. Da Wärmeausdehnungskoeffizient von glasfaserverstärkter Kunststoff in Faserrichtung im Bereich von ca. 10-12 X 10⁻⁶ pro Kelvin und damit zwischen dem von Aluminium und kohlefaserverstärktem Kunststoff liegt, kann das thermische Ausdehnungsverhalten der CFK-Schicht im Monagebereich 11 durch die die Verbindung mit dem GFK-Unterstützungselement 25 manipuliert und dem thermischen Ausdehnungsverhalten der Führungseinrichtung 12 aus Aluminium-Legierung angenähert werden. Durch die Verwendung einer Aluminium-Silicium-Legierung, deren Wärmeausdehnungskoeffizient näher an dem von GFK liegt, kann die Annäherung des thermischen Ausdehnungsverhaltens weiter verbessert werden. Somit wird erreicht, dass die thermischen Spannungen zwischen der Führungseinrichtung 12 und dem Trägerarm 2 und damit auch eventuelle Verformungen der Führungseinrichtungen 12 deutlich reduziert werden, was sich positiv auf die Positioniergenauigkeit des Trägerarmes auswirkt.

Die optimale Anpassung des thermischen Ausdehnungsverhaltens der übereinander liegenden Schichten aus GFK und CFK an das der Führungseinrichtung 12 erfordert eine entsprechende Auslegung der Einzelschichten erreicht. Grundsätzlich ist das thermische Ausdehnungsverhalten der CFK-Platten 24 des Grundkörpers 22 und das des GFK-Unterstützungselements 25 von mehreren Parametern abhängig. Dazu zählen insbesondere der Typ des verwendeten CFK-Werkstoffs bzw. GFK-Werkstoffs, die Wärmeausdehnung und der Elastizitäts-Modul in Faserrichtung der beiden Werkstoffe. Ferner zählen dazu die jeweilige Anzahl der die Platten bzw. Schichten bildenden Lagen aus CFK bzw. GFK und die Winkellage der Fasern zueinander. Die Form und die Werkstoffeigenschaften der Führungseinrichtung 12 sind in der Regel vorgegeben und sind nicht oder nur geringfügig veränderbar.

Eine derartige Optimierung der Auslegung der CFK-Schicht und der GFK-Schicht ist beispielsweise durch Einsatz des frei erwerbbaren Computerprogramms "ANSYS" auf Basis der Finite-Elemente-Methode möglich. Die Optimierung kann dabei so durchgeführt werden, dass dem Programm in einem ersten Schritt die oben genannten Werkstoffparameter und die geometrischen Daten des Trägerarms zugeführt werden. Unter Angabe von Wärmequellen, wie beispielsweise der Linearmotor, und Wärmesenken, wie beispielsweise Konvektion, berechnet das Programm ein Wärmeverteilungsprofil, eine Gesamtwärmeausdehnung und daraus ein Verformungsbild des Trägerarms 2. Daraus kann dann auf die Belastungen an der Führungseinrichtung 12 und die Positioniergenauigkeit geschlossen werden. Die Abstimmung der CFK-Schicht bzw. der GFK-Schicht auf die Führungseinrichtung 12 erfolgt dann durch iteratives Verändern der oben genannten Parameter bis zu einem Punkt, an dem die Lagerbelastung minimal und die Positioniergenauigkeit maximal sind. Nach diesen Vorgaben kann der Trägerarm 2 dann gebaut werden.

### Bezugszeichenliste

- 1: Bestückautomat
- 2: Trägerarm
- 3: Substrat
- 4: Transportstrecke
- 5: Zuführeinrichtung
- 6: Elektrische Bauelemente
- 7: Bestückkopf
- 8: Positioniersystem
- 9: Linearführung
- 10: Querführung
- 11: Montagebereich
- 12: Anbauelement / Führungseinrichtung
- 13: Montagewinkel
- 14: Führungswagen
- 15: Schienen
- 16: Montagefläche
- 17: Mobiles Spulenteil
- 18: Permanentmagnete
- 19: Weitere Permanentmagnete
- 20: Weiteres mobiles Spulenteil
- 21: Greifermodule
- 22: Grundkörper
- 23: Seitenwand mit Montagebereich
- 24: CFK-Platten
- 25: Unterstützungselement
- 26: Schaumstoffkörper

## Patentansprüche

1. Trägerarm (2), insbesondere zum Tragen eines Bestückkopfs (7) für einen Bestückautomat (1) zum Bestücken von Substraten mit elektrischen Bauelementen (6), mit
- einem Grundkörper (22), der kohlefaserverstärkten Kunststoff aufweist,
- einem Anbauelement (12), welches eine Montagefläche (16) aufweist, mit der das Anbauelement (12) in einem Montagebereich (11) am Trägerarm (2) befestigt ist, und
- einem Unterstützungselement (25), welches glasfaserverstärkten Kunststoff aufweist und im Montagebereich (11) mit dem Grundkörper (22) derart verbunden ist, dass die Montagefläche (16) des Anbauelements (12) zumindest teilweise von zwei übereinander angeordneten Schichten aus kohlefaserverstärktem Kunststoff des Grundkörpers (22) und glasfaserverstärkten Kunststoff des Unterstützungselements (25) unterlegt ist.

2. Trägerarm (2) nach Anspruch 1, wobei die Montagefläche (16) des Anbauelements (12) von den zwei übereinander angeordneten Schichten aus kohlefaserverstärktem Kunststoff des Grundkörpers (22) und glasfaserverstärkten Kunststoff des Unterstützungselements (25) vollständig unterlegt ist.

3. Trägerarm (2) nach einem der Ansprüche 1 bis 2, mit mehreren Anbauelementen (12), wobei für jedes Anbauelement (12) jeweils ein Unterstützungselement (25) vorgesehen ist.

4. Trägerarm (2) nach einem der Ansprüche 1 bis 3, wobei
- der Grundkörper (22) des Trägerarms (2) als kastenförmiger Hohlkörper ausgebildet ist,
- eine Seitenwand (23) des Grundkörpers (22), an der ein Anbauelement (12) befestigt ist, als zwei übereinander angeordnete, beabstandete kohlefaserverstärkte Kunststoffplatten (24) ausgebildet ist, und
- das jeweilige Unterstützungselement (25) zwischen den Kunststoffplatten (24) vorgesehen ist.

5. Trägerarm (2) nach Anspruch 4, wobei ein zwischen den beiden Kunststoffplatten (24) einer Seitenwand (23) verbleibende Hohlraum mit Schaumstoff ausgefüllt ist.

6. Trägerarm (2) nach einem der Ansprüche 1 bis 5, wobei jedes Anbauelement (12) einen metallischen Werkstoff, insbesondere eine Aluminium-Silicium-Legierung aufweist.

7. Trägerarm (2) nach einem der Ansprüche 1 bis 6, **dadurch gekennzeichnet, dass** das Anbauelement (12) eine Führungseinrichtung (12) ist, welche am Trägerarm (2) befestigt ist, sodass sie mit Schienen (15) einer Linearführung (9) des Bestückautomats (1) in Eingriff bringbar ist.

8. Bestückautomat (1) zum Bestücken von Substraten mit elektrischen Bauelementen (6), mit einem Trägerarm (2) nach Anspruch 7.

## Claims

1. Arm (2), in particular for supporting a head (7) of a mounting device (1) for assembling substrates with electrical components (6) having
- a base body (22), which has carbon fibre-reinforced plastic,
- an attachment (12), which has a mounting surface (16), with which the attachment (12) is fastened to the arm (2) in an assembly region (11), and
- a support element (25), which has glass fibre-reinforced plastic and is linked to the base body (22) in the assembly region (11) such that the assembly surface (16) of the attachment (12) is at least partially underlayed by two layers of carbon fibre-reinforced plastic of the base body (22) and glass fibre-reinforced plastic of the support element (25) arranged one above the other

2. Arm (2) according to claim 1, with the assembly surface (16) of the attachment (12) being completely underlayed by the two layers of carbon fibre-reinforced plastic of the base body (22) and glass-fibre-reinforced plastic of the support element (25) arranged one above the other.

3. Arm (2) according to one of claims 1 to 2, having several attachments (12), with a support element (25) being provided in each instance for each attachment (12).

4. Arm (2) according to one of claims 1 to 3, with
- the base body (22) of the arm (2) being embodied as a box-shaped cavity,
- a side wall (23) of the base body (22), to which an attachment (12) is fastened, being embodied as two carbon fibre-reinforced plastic plates (24) which are distanced from one another and are arranged one above the other , and
- the respective support element (25) being provided between the plastic plates (24).

5. Arm (2) according to claim 4, with a cavity remaining between the two plastic plates (24) of a side wall (23) being filled with foam.

6. Arm (2) according to one of claims 1 to 5, with each attachment (12) having a metallic material, in particular an aluminium silicon alloy.

7. Arm (2) according to one of claims 1 to 6, **characterised in that** the attachment (12) is a guiding device (12), which is fastened to the arm (2), so that it can be engaged with rails (15) of a linear guide (9) of the mounting device (1).

8. Mounting device (1) for assembling substrates with electrical components (6), having an arm (2) according to claim 7.

## Revendications

1. Bras support (2), en particulier destiné à porter une tête d'équipement (7) pour un automate d'équipement (1) pour équiper des substrats avec des composants (6) électriques, comprenant
- un corps de base (22) qui présente un plastique renforcé de fibre de carbone,
- un élément de montage (12), qui présente une surface de montage (16), avec laquelle l'élément de montage (12) est fixé dans une zone de montage (11) sur le bras support (2), et
- un élément de soutien (25), qui présente un plastique renforcé de fibre de verre et est relié dans la zone de montage (11) au corps de base (22) de telle sorte que la surface de montage (16) de l'élément de montage (12) est garnie au moins en partie par deux couches disposées l'une au-dessus de l'autre à base de plastique renforcé de fibre de carbone du corps de base (22) et de plastique renforcé de fibre de verre de l'élément de soutien (25).

2. Bras support (2) selon la revendication 1, la surface de montage (16) de l'élément de montage (12) étant garnie complètement par les deux couches disposées l'une au-dessus de l'autre à base de plastique renforcé de fibre de carbone du corps de base (22) et de plastique renforcé de fibre de verre de l'élément de soutien (25).

3. Bras support (2) selon l'une quelconque des revendications 1 à 2, comprenant plusieurs éléments de montage (12), à chaque fois un élément de soutien (25) étant prévu pour chaque élément de montage (12).

4. Bras support (2) selon l'une quelconque des revendications 1 à 3,
- le corps de base (22) du bras support (2) étant conçu sous forme de corps creux en forme de caisse,
- une paroi latérale (23) du corps de base (22), sur laquelle est fixé un élément de montage (12), étant conçue sous forme de deux plaques plastique (24) disposées l'une au-dessus de l'autre, espacées et renforcées de fibre de carbone, et
- l'élément de soutien (25) respectif étant prévu entre les plaques plastique (24).

5. Bras support (2) selon la revendication 4, une cavité restant entre deux plaques plastique (24) d'une paroi latérale (23) étant remplie avec de la mousse.

6. Bras support (2) selon l'une quelconque des revendications 1 à 5, chaque élément de montage (12) présentant un matériau métallique, en particulier un alliage d'aluminium et de silicium.

7. Bras support (2) selon l'une quelconque des revendications 1 à 6, **caractérisé en ce que** l'élément de montage (12) est un système de guidage (12) qui est fixé sur le bras support (2) de telle sorte qu'il peut être amené en prise avec des rails (15) d'un guide linéaire (9) de l'automate d'équipement (1).

8. Automate d'équipement (1) pour équiper des substrats avec des composants (6) électriques, comprenant un bras support (2) selon la revendication 7.
